# EUROPEAN PATENT APPLICATION

(11) **EP 4 847 928 A1**
(43) Date of publication of application: **02.12.2026**
(21) Application number: 25179583.7
(22) Date of filing: 28.05.2025
(51) Int. Cl.: G01R 31/00, G01R 31/66

(54) **MEASUREMENT CIRCUIT FOR A HIGH-VOLTAGE INTERLOCK LOOP SYSTEM**

(71) Applicant: SAMSUNG SDI CO., LTD., Yongin-si, Gyeonggi-do 17084 (KR)
(72) Inventor: Gombats, Ilya, 8020 Graz (AT); Pretschuh, Markus, 8055 Graz (AT)
(74) Representative: Gulde & Partner

(57) **Abstract**

The present disclosure refers to a measurement circuit for a high-voltage interlock loop, HVIL, system for a vehicle (20), including: a voltage source (50, 51) providing a voltage signal to a series connection of code resistors (R1, R2, R3); a HVIL measuring device (62) configured to determine a resistance value of the series connection of code resistors (R1, R2, R3); and at least two connectors (31, 32) configured to electrically connect a high-voltage, HV, battery (10) to the vehicle (20), wherein each of the connectors (31, 32) is configured to establish an electrical conductor loop (A, B) between the measurement circuit on the HV battery (10) side and the vehicle (20) side of the connectors (31,32), wherein, for each connector (31, 32), the electrical conductor loops (A, B) are formed such that at least one code resistor (R1, R2, R3) in the series connection of code resistors (R1, R2, R3) is bridged by the electrical conductor loop (A, B) when the electrical conductor loop (A, B) is established, and wherein a deviation in the resistance value of the series connection of code resistors (R1, R2, R3) when the respective electrical conductor loop (A, B) is established is specific for each connector (31, 32).

## Description

### Field of the Disclosure

Embodiments of the present disclosure relate to a measurement circuit for a high-voltage interlock loop (HVIL) system and a corresponding method for operating the measurement circuit.

### Technological Background

Recently, vehicles for transportation of goods and peoples have been developed that use electric power as a source for motion. Such an electric vehicle is an automobile that is propelled permanently or temporarily by an electric motor using energy stored in rechargeable batteries. An electric vehicle may be solely powered by batteries (Battery Electric Vehicle BEV) or may include a combination of an electric motor and, for example, a conventional combustion engine (Plugin Hybrid Electric Vehicle PHEV). BEVs and PHEVs use high-capacity rechargeable batteries, which are designed to provide power for propulsion over sustained periods of time.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, SoC, potential electrical performance, charging ability and internal resistance as well as actual or predicted power demands or surpluses of the consumers. Therefore, battery systems usually include a battery management system, BMS, for obtaining and processing such information on system level and further a plurality of battery module managers, BMMs, which are part of the system's battery modules and obtain and process relevant information on module level. Particularly, the BMS usually measures the system voltage, the system current, the local temperature at different places inside the system housing, and the insulation resistance between live components and the system housing. Additionally, the BMMs usually measure the individual cell voltages and temperatures of the battery cells in a battery module.

Thus, the BMS is provided for managing the battery pack, such as by protecting the battery from operating outside its safe operating area, monitoring its state, calculating secondary data, reporting that data, controlling its environment, authenticating it and/or balancing it.

In case of an abnormal operation state, a battery pack shall usually be disconnected from a load connected to a terminal of the battery pack. Therefore, battery systems further include a battery disconnect unit, BDU, that is electrically connected between the battery module and battery system terminals. Thus, the BDU is the primary interface between the battery pack and the electrical system of the vehicle. The BDU includes electromechanical switches that open or close high current paths between the battery pack and the electrical system. The BDU provides feedback to the battery control unit, BCU, accompanied to the battery modules such as voltage and current measurements. The BCU controls the switches in the BDU using low current paths based on the feedback received from the BDU. The main functions of the BDU may thus include controlling current flow between the battery pack and the electrical system and current sensing. The BDU may further manage additional functions like external charging and pre-charging.

A high-voltage interlock loop, HVIL, is an essential safety mechanism integrated into the design and functionality of BEVs and PHEVs. This system is primarily aimed at mitigating the risks associated with the high-voltage components that are characteristic of these vehicular technologies. The HVIL system operates by employing a continuous, low-voltage electrical conductor loop that is meticulously interwoven with the high-voltage architecture of the vehicle.

The HVIL system is based on the principle of continuous monitoring. It ensures that a low-voltage signal traverses through all high-voltage connectors and components. This low-voltage loop acts as a sentinel, constantly verifying the integrity and security of high-voltage connections. In the event of a disconnection or fault within the high-voltage system, the continuity of this low-voltage loop is disrupted.

When the HVIL detects an interruption in the low-voltage electrical conductor loop, it may trigger a rapid and systematic response. This response may involve the generation of a diagnostic trouble code, DTC, within the vehicle's onboard diagnostic system or a notification to the BMS. The DTC may serve as an alert to both the driver and maintenance personnel, indicating a potential issue within the high-voltage system that requires immediate attention. The disruption of the HVIL loop may prompt the vehicle or the BMS to initiate protective measures, including the shutdown of high-voltage circuits, thereby preventing the risk of electric shock or fire. By providing a robust and reliable means of monitoring and safeguarding high-voltage components, the HVIL system enhances both the operational safety and reliability of hybrid and electric vehicles.

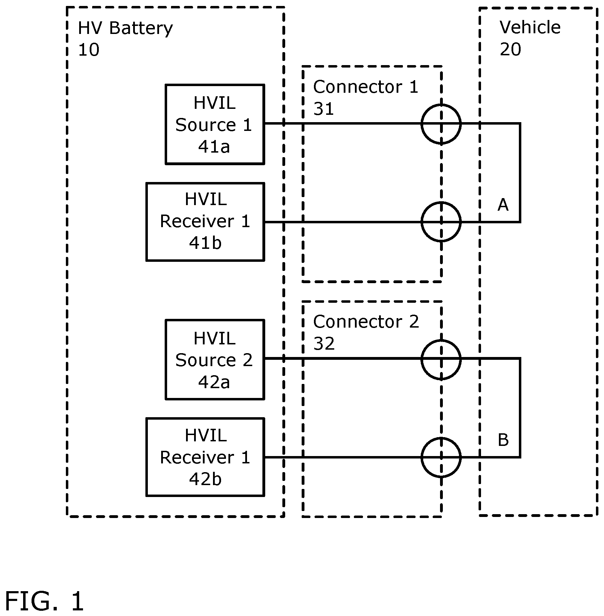

The current state-of-the-art approach for the HVIL involves utilizing an independent loop for each connection. Each of these electrical conductor loops must be diagnosed separately and accurately identified in the event of a failure. To illustrate this, an exemplarily scenario with only two connectors may be considered (see FIG. 1). If one of these connectors is disconnected, the system needs to detect precisely which connector has been affected. The contemporary solution to this problem is to establish an independent electrical conductor loop for each connector. This setup entails that each independent loop includes one HVIL source and one HVIL receiver. The HVIL signal typically consists of a constant current, although it can also be implemented as a pulse width modulation, PWM, signal.

Since the prior art solution necessitates the implementation of independent electrical conductor loops for each connector, this implies that each loop requires its own dedicated current source, in addition to at least two independent voltage measurement channels and current measurement channels. Consequently, this approach involves a substantial number of components. The reliance on numerous components may increase complexity in the system design, higher costs associated with procuring and maintaining these components, and potential challenges in troubleshooting and diagnosing issues within a more intricate setup. Additionally, the increased number of components may contribute to higher overall weight and space requirements, which could impact the efficiency and design flexibility of the vehicle.

### Summary of Invention

The invention is defined by the appended claims. The description that follows is subjected to this limitation. Any disclosure lying outside the scope of the claims is only intended for illustrative as well as comparative purposes.

According to an embodiment of an aspect of the present disclosure, a measurement circuit for a high-voltage interlock loop (HVIL) system for a vehicle includes a voltage source providing a voltage signal to a series connection of code resistors; a HVIL measuring device configured to determine a resistance value of the series connection of code resistors; and at least two connectors configured to electrically connect a high-voltage (HV) battery to the vehicle, wherein each of the connectors is configured to establish an electrical conductor loop between the measurement circuit on the HV battery side and the vehicle side of the connectors, wherein, for each connector, the electrical conductor loops are formed such that at least one code resistor in the series connection of code resistors is bridged by the electrical conductor loop when the electrical conductor loop is established, and wherein a deviation in the resistance value of the series connection of code resistors when the respective electrical conductor loop is established is specific (or individualized) for each connector.

According to another embodiment, the resistance values of at least some code resistors in the series connection of code resistors may differ in a specifically defined manner to allow identification of the individual connectors that establish a respective electrical conductor loop.

According to another embodiment, the voltage source may be a pulse width modulation (PWM) source.

According to another embodiment, the HVIL system may further include a voltage diagnostic device configured to detect signal failures. The voltage diagnostic device may be a PWM diagnostic device.

According to another embodiment, the voltage source may provide a low voltage (LV) signal.

According to another embodiment, the voltage source may provide a low frequency signal. The frequency of the low frequency signal may be in the range of several Hz, e.g., 2 Hz to 20 Hz.

According to another embodiment, the voltage source may provide a signal with levels of 5 V to 2.5 V.

According to another embodiment, at least one code resistor in the series connection of code resistors may not to be bridged by the electrical conductor loops established by the connectors.

According to another embodiment, the series connection of code resistors may be connected in series with a measurement resistor which may form with the code resistors of the series connection of code resistors a resistive voltage divider, wherein a voltage may be measured over the measurement resistor by the HVIL measuring device to determine a resistance value of the series connection of code resistors.

According to yet another embodiment, the vehicle may include an additional test switch to bridge all code resistors for testing.

According to an embodiment of another aspect of the present disclosure, a HVIL system for a vehicle may include a measurement circuit according to the present disclosure.

According to an embodiment of another aspect of the present disclosure, a vehicle may include a HVIL system according to the present disclosure.

According to an embodiment of yet another aspect of the present disclosure, a method for operating a HVIL system includes providing a HVIL system according to the present disclosure; and providing a voltage signal to the series connection of code resistors.

According to another embodiment, the method may further include connecting the high-voltage (HV) battery to the vehicle by at least one connector of the at least two connectors.

According to another embodiment, the method may further include determining a resistance value of the series connection of code resistors.

According to yet another embodiment, the method may further include comparing the determined resistance value to a known reference value; and determining a specific condition in the HVIL system based on the deviation of the determined resistance value being specific (or individualized) for each connector when the respective electrical conductor loop is established.

Further embodiments of the present disclosure could be learned from the dependent claims or the following description.

### Brief Description of the Drawings

Features will become apparent to those of ordinary skill in the art by describing in detail exemplary embodiments with reference to the attached drawings in which:
- FIG. 1: illustrates a schematic view of a HVIL system according to the prior art.
- FIG. 2: illustrates a schematic view of a HVIL system including a measurement circuit according to an exemplary embodiment.
- FIG. 3: illustrates a schematic view of a HVIL system including a measurement circuit according to the exemplary embodiment of FIG. 2 in a first condition.
- FIG. 4: illustrates a schematic view of a HVIL system including a measurement circuit according to the exemplary embodiment of FIG. 3 in a second condition.
- FIG. 5: illustrates a schematic view of a HVIL system including a measurement circuit according to another embodiment.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the embodiments and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Expressions such as "at least one of", when preceding a list of elements, modify the entire list of elements and do not modify the individual elements of the list. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

The term "consisting essentially of" means that specific further components can be present, namely those not materially affecting the essential characteristics of a composition.

It will also be understood that when a film, a region, or an element is referred to as being "above" or "on" another film, region, or element, it can be directly on the other film, region, or element, or intervening films, regions, or elements may also be present.

Herein, the terms "upper" and "lower" are defined according to the z-axis. For example, the upper cover is positioned at the upper part of the z-axis, whereas the lower cover is positioned at the lower part thereof. In the drawings, the sizes of elements may be exaggerated for clarity. For example, in the drawings, the size or thickness of each element may be arbitrarily shown for illustrative purposes, and thus the embodiments of the present disclosure should not be construed as being limited thereto.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may include metallization, e.g. surface metallizations and/or pins, and/or may include conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the exemplary embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

### General Concept

According to an embodiment of an aspect of the present disclosure, a measurement circuit for a high-voltage interlock loop (HVIL) system for a vehicle includes a voltage source providing a voltage signal to a series connection of code resistors. The voltage source may be connected to one end of the series connection. The other end of the series connection may be connected to a ground, either directly or via further electrical elements. The voltage signal may be constant or alternating, preferably a modulated, low voltage (LV) signal. The term code resistors is used to specifically refer to the resistors which form the core elements of the disclosed measurement circuit. The code resistors may have an electrical resistance that allows to discriminate between the various resistors in the series connection by means of the effective electrical resistance of the series connection when at least one of the code resistor is bridged.

The measurement circuit further includes a HVIL measuring device configured to determine a resistance value of the series connection of code resistors. The HVIL measuring device may measure the resistance via a resistive voltage divider in which the measured voltage corresponds to the resistance value of the series connection.

At least two connectors are configured to electrically connect a high-voltage (HV) battery to the vehicle. Such connectors are well-known in the art. The connectors may be configured to provide a common HV level or different HV levels from the HV battery to the vehicle.

Each of the connectors is configured to establish an electrical conductor loop between the measurement circuit on the HV battery side and the vehicle side of the connectors. These electrical conductor loops are a core element of a HVIL system. They may provide an electrical connection from the HV battery side through the connector towards the vehicle side and then back to the HV battery side. Since the electrical conductor loops are formed together with a respective HV connection, they allow to independently check whether the HV connection has been established correctly or not. In the prior art, each electrical conductor loop is driven by a LV signal from an independent HVIL source and detected by a corresponding HVIL receiver.

However, in the present disclosure, for each connector, the electrical conductor loops are formed such that at least one code resistor in the series connection of code resistors is bridged by the electrical conductor loop when the electrical conductor loop is established. That means, instead of having an independent HVIL source and a corresponding HVIL receiver for each electrical conductor loop, the electrical conductor loops are all connected to a single series connection of code resistors and thus to a single HVIL source, namely a voltage source as described above. The bridging creates a short-circuited parallel circuit across the respective at least one code resistor and thus the overall resistance value for the at least one bridged code resistor and thus of the series connection may be reduced or otherwise modified in a well-defined manner.

The code resistors may be coded such that a deviation in the resistance value of the series connection of code resistors when the respective electrical conductor loop is established is specific for each connector. That means that bridging may individually change the electrical resistance of the series connection of code resistors such that the establishment of a respective loop and thus of the related HV connection of the corresponding connector allows to discriminate between the different connectors. For example, the code resistors may be defined such that for each possible connection condition (e.g., such as none, one or two connectors being connected) a specifically defined resistance value for the series connection of code resistors may be measurable.

In other words, the present disclosure is related to using a coded series connection of resistors in which each electrical conductor loop of the HVIL system allows to bridge a corresponding code resistor such that the overall resistivity of the coded series connection is able to identify a malfunction of one or more connectors. There may be separate and non-overlapping resistivity regions for the resulting values of the overall resistivity of the coded series connection defined to enable a clear and unambiguous discrimination between the individual voltage drops at the coded resistors.

According to the present disclosure, several HVIL loops are thus connected into one measurement circuit but the HVIL system still allows to have the option to identify at which point in the HV connection a fault occurs. The provided solution becomes possible by including code resistors for each loop. Instead of providing an individual HVIL source and receiver for each connector as in the in prior art, the present disclosure uses a coded series connection of resistors in which each HVIL loop allows to bridge a corresponding resistor such that the overall resistivity of the coded series connection is able to identify a malfunction of one or more connectors.

According to another embodiment, the resistance values of at least some code resistors in the series connection of code resistors may differ in a specifically defined manner to allow identification of the individual connectors that establish a respective electrical conductor loop. A specifically defined manner may be, e.g., a specific ratio or increase between different code resistors, or a characteristic but non-related selection of individual, non-overlapping resistance values. A specific selection of resistance values allows to optimize the analysis of the measurement results and thus of the discrimination between different connectors and faults. For example, the code resistors can form a series in which each code resistor has a resistance value that is a ten or hundred times as high as the resistance value of its immediate predecessor. In such a case, the connectors could be easily identified by the respective resistance range of the corresponding code resistor (e.g., 10 kΩ range related to a first connector, 100 kΩ range related to a second connector etc.).

According to another embodiment, the voltage source may be a pulse width modulation (PWM) source. PWM is a widely utilized technique that involves modulating the width of pulses in a pulse train to encode information or control power delivery to electronic devices. This modulation technique works by varying the duty cycle of a periodic digital signal, where the duty cycle is defined as the percentage of one period in which the signal is active. For instance, a PWM signal with a duty cycle of 50% means that the signal is active for half of its period and inactive for the other half. By adjusting the duty cycle, PWM can effectively control the average power delivered to a load without the need for complex analog circuitry. The primary advantage of PWM lies in its ability to provide precise control over the amount of power delivered to a load. This is achieved by rapidly switching the signal on and off, thus creating an average voltage that can be adjusted by changing the duty cycle. This method is highly efficient as the switching devices (typically transistors) operate in either fully on or fully off states, minimizing energy losses due to heat dissipation.

In HVIL systems, PWM may be employed for several compelling reasons. One of the primary advantages of PWM is its ability to provide precise modulation of signals, enabling accurate monitoring and control of the HVIL system. By varying the duty cycle of the PWM signal, the system can effectively manage and detect changes in the high-voltage interlock status, ensuring a robust safety mechanism. Moreover, PWM signals maintain their integrity over long distances. This robustness ensures that the signal remains consistent and reliable, even when transmitted over extended lengths. In addition, PWM's resilience to electromagnetic interference makes it particularly advantageous in the electrically noisy environment of vehicles. Unlike analog signals, PWM signals are less susceptible to such interference, guaranteeing reliable operation of the HVIL system amidst the myriad of electronic noise sources present in automotive settings .The diagnostic capabilities of PWM are another significant benefit. PWM can embed diagnostic information within the signal itself, facilitating advanced diagnostics and troubleshooting. This allows for detailed monitoring and quick identification of issues related to the high-voltage connections, thereby enhancing the safety and efficiency of vehicle maintenance and operation.

Accordingly, the HVIL system may further include a voltage diagnostic device like a PWM diagnostic device configured to detect signal failures. The PWM diagnostic device may constantly check the presence and/or quality of the PWM signal to ensure the proper function of the measurement circuit. The measurement circuit may thus be always under some voltage and the PWM diagnostic device may easily detect such failures like short to ground or a physical interruption of the circuit.

According to another embodiment, the voltage source may provide a low voltage (LV) signal. The connectors of the HVIL system may be configured to establish an electrical conductor loop between the measurement circuit on the HV battery side and the vehicle side of the connectors. By using a low LV signal for the electrical conductor loops of the HVIL system, the measurement circuit can be functionally separated from the HV system and the safety requirements for the electric circuit are typically lower compared to HV circuits. Furthermore, since the measurement circuit has very low power requirements, the use of LV signals is sufficient in most cases.

According to another embodiment, the voltage source may provide a low frequency signal, preferably in the range of several Hz. Low frequency signals are sufficient in most cases and thus the requirements for electromagnetic compatibility (EMC) can be minimized.

According to another embodiment, the voltage source may provide a signal with levels of 5 V to 2.5 V. This voltage range corresponds to a typical range for LV electronics and may be supplied by a general purpose input/output (GPIO).

According to another embodiment, at least one code resistor in the series connection of code resistors may not to be bridged by the electrical conductor loops established by the connectors. The at least one non-bridgeable code resistor may be used to detect if pins (HVIL pins) for providing a connection of the electrical conductor loops of the connectors of the HVIL system are shorted due to some failure. If they are shorted or there is an dirty disturbance as particle or some residue, then the resistance of corresponding code resistor will be changed and may be recognized during an initialization procedure of the measurement circuit. With such diagnostic function it becomes possible to place the HVIL pins very close to each other and thus some space on the corresponding board may be saved.

According to another embodiment, the series connection of code resistors may be connected in series with a measurement resistor which may form with the code resistors of the series connection of code resistors a resistive voltage divider, wherein a voltage may be measured over the measurement resistor by the HVIL measuring device to determine a resistance value of the series connection of code resistors. A resistive voltage divider is a simple but effective method for measuring the resistance value of the series connection of code resistors.

According to yet another embodiment, the vehicle may include an additional test switch to bridge all code resistors for testing. The test switch may be used to check the proper functioning of the measuring circuit and its components.

According to an embodiment of another aspect of the present disclosure, a high-voltage interlock loop (HVIL) system for a vehicle may include a measurement circuit according to the present disclosure. The HVIL system may be part of an electric system of the vehicle which relates to all electric installations of the vehicle including corresponding LV and HV components.

According to an embodiment of another aspect of the present disclosure, a vehicle may include a HVIL system according to the present disclosure.

According to an embodiment of yet another aspect of the present disclosure, a method for operating a high-voltage interlock loop (HVIL) system includes providing a HVIL system according to the present disclosure; and providing a voltage signal to the series connection of code resistors. The voltage signal may be applied by the voltage source.

According to another embodiment, the method may further include connecting the high-voltage (HV) battery to the vehicle by at least one connector of the at least two connectors. Since the HVIL system is to monitor the proper function of the connectors, at least one connector has to be connected to be monitored.

According to another embodiment, the method may further include determining a resistance value of the series connection of code resistors. A deviation in the resistance value of the series connection of code resistors when the respective electrical conductor loop is established is specific for each connector.

According to yet another embodiment, the method may further include comparing the determined resistance value to a known reference value; and determining a specific condition in the HVIL system based on the deviation of the determined resistance value being specific for each connector when the respective electrical conductor loop is established. The known reference value may be a set or determine resistance value for the series connection of code resistors for the case that all electric conductor loops (HVIL loops) are closed. Due to the specific and individualized coding of the resistors, any deviation in the measured resistance value can be traced back to a specific HVIL condition or connector failure.

All described method steps directly follow from the respective features of a measurement circuit or a HVIL system according to the present disclosure and thus their corresponding technical effects and resulting advantages can directly be derived from the respective features as described above in detail.

### Specific Embodiments

FIG. 1 is a schematic view of a HVIL system according to the prior art. The HVIL systems shown in FIG. 1 and all following figures are only illustrating the general concept of the different HVIL systems in the prior art and in the present disclosure. In particular, the number of connectors, electric conductor loops, code resistors and other components is not limited to these examples and has been restricted in the figures to embodiments including two connectors only for illustrational purposes.

The shown prior art HVIL system for a vehicle 20 includes a first HVIL source 41a and a second HVIL source 42a, each configured to provide a signal to a respective first HVIL receiver 41b and a second HVIL receiver 42b via respective electrical conductor loops A, B. These HVIL loops are established by the connection of at least two connectors 31, 32 which are configured to electrically connect a HV battery 10 to the vehicle 20. The connectors 31, 32 are thus configured to provide an electrical HV connection together with the electrical conductor loops A, B for the HVIL connection. That means that in prior art HVIL systems independent electrical conductor loops A, B are required for each connector 31, 32. Each of these HVIL loops A, B thus requires its own independent HVIL source 41a, 42a, which may be current or a voltage source, and its own receiver 41b, 42b to detect whether the respective loop A, B is closed by the corresponding connector connection.

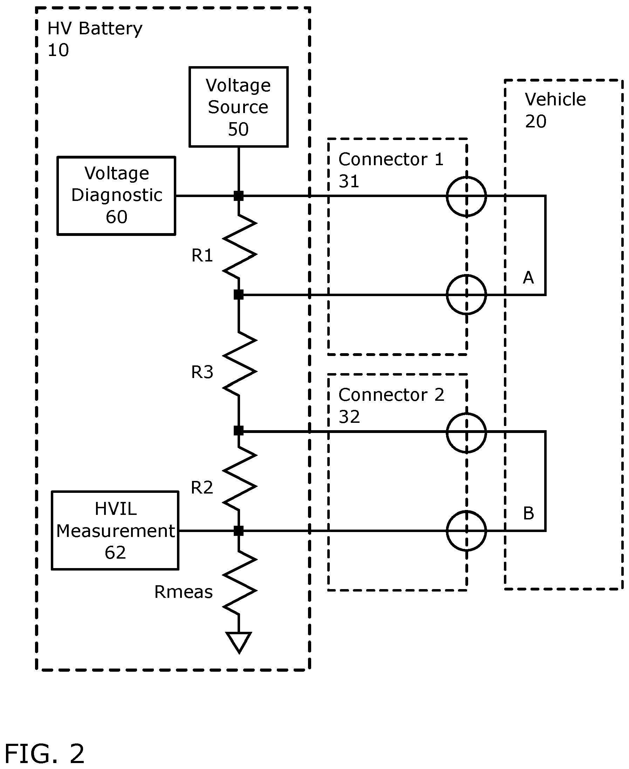

FIG. 2 illustrates a schematic view of a HVIL system including a measurement circuit according to an exemplary embodiment. The shown measurement circuit for the HVIL system for a vehicle 20 includes a voltage source 50 providing a voltage signal to a series connection of code resistors R1, R2, R3; a HVIL measuring device 62 configured to determine a resistance value of the series connection of code resistors R1, R2, R3; and at least two connectors 31, 32 configured to electrically connect a high-voltage (HV) battery 10 to the vehicle 20, wherein each of the connectors 31, 32 is configured to establish an electrical conductor loop A, B between the measurement circuit on the HV battery 10 side and the vehicle 20 side of the connectors 31,32, wherein, for each connector 31, 32, the electrical conductor loops A, B are formed such that at least one code resistor R1, R2, R3 in the series connection of code resistors R1, R2, R3 is bridged by the electrical conductor loop A, B when the electrical conductor loop A, B is established, and wherein a deviation in the resistance value of the series connection of code resistors R1, R2, R3 when the respective electrical conductor loop A, B is established is specific for each connector 31, 32.

The shown HVIL system further includes a diagnostic device 60 configured to detect voltage signal failures. The resistance values of at least some code resistors R1, R2, R3 in the series connection of code resistors R1, R2, R3 may differ in a specifically defined manner to allow identification of the individual connectors 31, 32 that establish a respective electrical conductor loop A, B. The voltage source 50 may provide a low voltage (LV) signal, preferably a signal with levels of 5 V to 2.5 V. Furthermore, the voltage source 50 may provide a low frequency signal, preferably in the range of several Hz.

At least one code resistor R3 in the series connection of code resistors R1, R2, R3 is not to be bridged by the electrical conductor loops A, B established by the connectors 31, 32. The at least one non-bridgeable code resistor R3 may be used to detect if pins (HVIL pins) for providing a connection of the electrical conductor loops A, B of the connectors of the HVIL system are shorted due to some failure. If they are shorted or there is an dirty disturbance as particle or some residue, then the resistance of the corresponding code resistor R3 will be changed and may be recognized during an initialization procedure of the measurement circuit. With such diagnostic function, it becomes possible to place the HVIL pins close to each other and thus to save some space on the corresponding board.

In the shown embodiment, the series connection of code resistors R1, R2, R3 is connected in series with a measurement resistor Rmeas which forms with the code resistors R1, R2, R3 of the series connection of code resistors R1, R2, R3 a resistive voltage divider, wherein a voltage is measured over the measurement resistor Rmeas by the HVIL measuring device 62 to determine a resistance value of the series connection of code resistors R1, R2, R3.

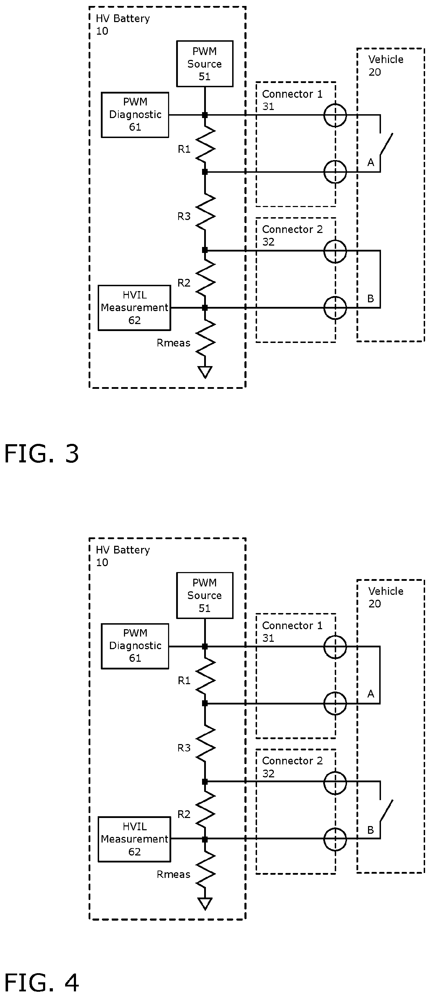

FIG. 3 illustrates a schematic view of a HVIL system according to the exemplary embodiment of FIG. 2 in a first condition. However, the voltage source 50 is shown as a pulse width modulation (PWM) source 51 in this example. Accordingly, the related voltage diagnostic device 60 is shown as a PWM diagnostic device 61. The PWM diagnostic device 61 may be configured to detect signal failures in the PWM signal provided by the PWM source 51.

The figure shows a condition in which only the second connector 32 establishes an electrical conductor loop B between the measurement circuit on the HV battery 10 side and the vehicle 20 side of the connectors 31, 32 and thus only the second code resistor R2 is bridged. The first connector 31 may not be properly connected or another failure has occurred such that the corresponding electrical conductor loop A is not closed and the first resistor R1 is not bridged. Since the effective electrical resistance of the second code resistor R2 is effectively reduced, a deviation in the resistance value of the series connection of code resistors R1, R2, R3 occurs which is then specific for the second connector 32.

FIG. 4 illustrates a schematic view of a HVIL system according to the exemplary embodiment of FIG. 3 in a second condition. Under this condition only the first connector 31 establishes an electrical conductor loop A between the measurement circuit on the HV battery 10 side and the vehicle 20 side of the connectors 31, 32 and thus only the first code resistor R1 is bridged. The second connector 32 may not be properly connected or another failure has occurred such that the corresponding electrical conductor loop B is not closed and the second resistor R2 is not bridged. Since the effective electrical resistance of the first code resistor R1 is effectively reduced, a deviation in the resistance value of the series connection of code resistors R1, R2, R3 occurs which is then specific for the first connector 31.

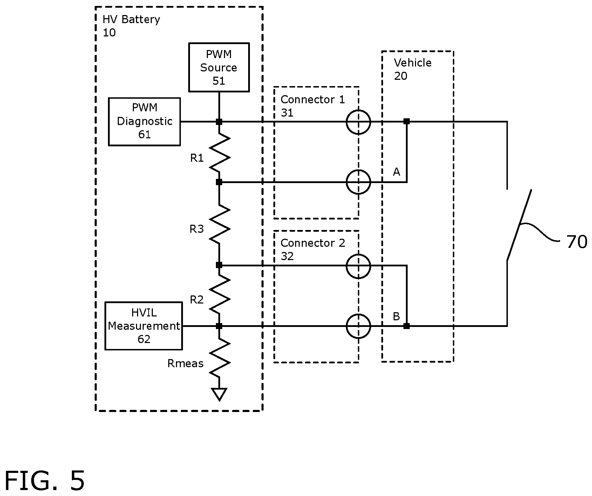

FIG. 5 illustrates a schematic view of a HVIL system according to another embodiment. In this embodiment, the vehicle 20 includes an additional test switch 70 to bridge all code resistors R1, R2, R3 for testing. However, the other parts of the shown measurement circuits correspond to the exemplarily shown embodiments of FIGs. 3 and 4. The test switch 70 may be used to check the proper functioning of the measuring circuit and its components.

### Reference signs

- 10: HV battery
- 20: Vehicle (e.g., hybrid or electric vehicle)
- 31: First connector
- 32: Second connector
- 41a: First HVIL source (first connector)
- 41b: First HVIL receiver (first connector)
- 42a: Second HVIL source (second connector)
- 42b: Second HVIL receiver (second connector)
- 50: Voltage source
- 51: PWM source
- 60: Voltage Diagnostic
- 61: PWM diagnostic device
- 62: HVIL measuring device
- 70: Test switch

- A: First electrical conductor loop
- B: Second electrical conductor loop
- R1: First code resistor
- R2: Second code resistor
- R3: Third code resistor
- Rmeas: Measurement resistor

## Claims

1. Measurement circuit for a high-voltage interlock loop, HVIL, system for a vehicle (20), comprising:
a voltage source (50, 51) providing a voltage signal to a series connection of code resistors (R1, R2, R3);
a HVIL measuring device (62) configured to determine a resistance value of the series connection of code resistors (R1, R2, R3); and
at least two connectors (31, 32) configured to electrically connect a high-voltage, HV, battery (10) to the vehicle (20), wherein each of the connectors (31, 32) is configured to establish an electrical conductor loop (A, B) between the measurement circuit on the HV battery (10) side and the vehicle (20) side of the connectors (31, 32),
wherein, for each connector (31, 32), the electrical conductor loops (A, B) are formed such that at least one code resistor (R1, R2, R3) in the series connection of code resistors (R1, R2, R3) is bridged by the electrical conductor loop (A, B) when the electrical conductor loop (A, B) is established, and
wherein a deviation in the resistance value of the series connection of code resistors (R1, R2, R3) when the respective electrical conductor loop (A, B) is established is specific for each connector (31, 32).

2. Measurement circuit of claim 1, wherein the resistance values of at least some code resistors (R1, R2, R3) in the series connection of code resistors (R1, R2, R3) differ in a specifically defined manner to allow identification of the individual connectors (31, 32) that establish a respective electrical conductor loop (A, B).

3. Measurement circuit of claim 1 or 2, wherein the voltage source (50, 51) is a pulse width modulation, PWM, source (51).

4. Measurement circuit of any one of the preceding claims, further comprising a voltage diagnostic device (60) or a PWM diagnostic device (61) configured to detect signal failures.

5. Measurement circuit of any one of the preceding claims, wherein the voltage source (50, 51) provides a low voltage, LV, signal.

6. Measurement circuit of any one of the preceding claims, wherein the voltage source (50, 51) provides a low frequency signal.

7. Measurement circuit of any one of the preceding claims, wherein the voltage source (50, 51) provides a signal with levels of 5 V to 2.5 V.

8. Measurement circuit of any one of the preceding claims, wherein at least one code resistor (R3) in the series connection of code resistors (R1, R2, R3) is not to be bridged by the electrical conductor loops (A, B) established by the connectors (31, 32).

9. Measurement circuit of any one of the preceding claims, wherein the series connection of code resistors (R1, R2, R3) is connected in series with a measurement resistor (Rmeas) which forms with the code resistors (R1, R2, R3) of the series connection of code resistors (R1, R2, R3) a resistive voltage divider, wherein a voltage is measured over the measurement resistor (Rmeas) by the HVIL measuring device (62) to determine a resistance value of the series connection of code resistors (R1, R2, R3).

10. Measurement circuit of any one of the preceding claims, wherein the vehicle (20) comprises an additional test switch (70) to bridge all code resistors (R1, R2, R3) for testing.

11. A high-voltage interlock loop, HVIL, system for a vehicle (20), comprising a measurement circuit according to any one of the preceding claims.

12. A vehicle (20), comprising a HVIL system according to claim 11.

13. Method for operating a high-voltage interlock loop, HVIL, system, comprising:
providing a HVIL system according to claim 11; and
providing a voltage signal to the series connection of code resistors (R1, R2, R3).

14. Method according to claim 13, further comprising:
determining a resistance value of the series connection of code resistors (R1, R2, R3).

15. Method according to claim 14, further comprising:
comparing the determined resistance value to a known reference value; and
determining a specific condition in the HVIL system based on the deviation of the determined resistance value being specific for each connector (31, 32) when the respective electrical conductor loop (A, B) is established.
